# EUROPEAN PATENT APPLICATION

(11) **EP 2 521 010 A1**
(43) Date of publication of application: **07.11.2012**
(21) Application number: 10840721.4
(22) Date of filing: 05.11.2010
(51) Int. Cl.: G06F 3/041, G02F 1/133, G02F 1/1333, G02F 1/136, G09F 9/00, G09F 9/30, G09G 3/20, G09G 3/36

(54) **DISPLAY DEVICE**

(30) Priority: 28.12.2009 JP 2009298032
(71) Applicant: Sharp Kabushiki Kaisha, Osaka-shi, Osaka 545-8522 (JP)
(72) Inventor: YAMAMOTO, Keiichi, Osaka-shi, Osaka 545-8522 (JP)
(74) Representative: Müller-Boré & Partner Patentanwälte
(86) International application number: PCT/JP2010/006523
(87) International publication number: WO 2011/080861

(57) **Abstract**

A display device includes detection sections each of which is arranged in an associated one of a plurality of pixels, and is configured to detect a pressed position; scan lines and detection lines formed on a first substrate; and a detection driver connected to the detection lines. When the first substrate or a second substrate is pressed, and the detection section in the pressed area is scanned with the scan line, the detection driver detects a voltage applied to the detection section via the detection line. An inspection line to which at least the scan lines or the detection lines are connected in parallel is further formed on the first substrate.

## Description

### TECHNICAL FIELD

The present invention relates to display devices for detecting position information on display screens.

### BACKGROUND ART

In recent years, thin display devices such as liquid crystal display devices have been widely used in various devices such as personal computers, mobile phones, PDAs, game instruments, etc. Moreover, display devices in which touch panels are provided over display panels to detect position information on display screens are also known.

As a type of touch panels, for example, a resistive film type, an optical type, etc. is generally known. In the resistive film type, a transparent conductive film is adhered to a surface of a substrate adhered to a display panel, and a transparent conductive film is adhered to a surface of a film facing the substrate, where the film is adhered to the surface of the substrate with a small gap provided between the surface of the substrate and the film. These transparent conductive films are brought into contact with each other at a position pressed by a fingertip, a stylus tip, or the like, thereby allowing a flow of a current, so that the position is detected.

However, a configuration including a touch panel arranged over a display panel has problems where display quality is likely to be reduced, and reducing the thickness of the entirety of the display device is difficult. For this reason, integrating the display panel with the touch panel has been proposed (for example, see Patent Documents 1 and 2).

Patent Document 1 discloses that a first touch electrode is arranged over a gate interconnect and a source interconnect of a TFT substrate included in a liquid crystal display panel, while a second touch electrode is arranged over a black matrix of a counter substrate, thereby forming the first and the second touch electrodes in a matrix pattern.

Patent Document 2 discloses that contact electrodes in pairs are arranged on a TFT substrate in a matrix pattern, where one of the contact electrodes in each pair is connected to a detection line extending in X direction, and the other of the contact electrodes is connected to a detection line extending in Y direction. When a common electrode formed on a counter substrate is brought into contact with the contact electrodes in a pair at a pressed position (also referred to as a touch position), the voltage of the common electrode is detected by the contact electrodes and the detection lines to detect the pressed position.

Moreover, Patent Document 3 discloses a display device in which projecting inspection spacers are formed on a counter substrate, and sensing unit inspection lines arranged to face the inspection spacers are formed on a TFT substrate, where surface heights of the sensing unit inspection lines differ from each other. On surfaces of the inspection spacers, a common electrode is formed. Some of the inspection spacers are in contact with the sensing unit inspection lines in advance to easily inspect operation of a sensor element for sensing a pressed position.

### CITATION LIST

### PATENT DOCUMENT

PATENT DOCUMENT 1: Japanese Patent Publication No. 2001-075074
PATENT DOCUMENT 2: Japanese Patent Publication No. 2008-122913
PATENT DOCUMENT 3: Japanese Patent Publication No. 2007-199718

### SUMMARY OF THE INVENTION

### TECHNICAL PROBLEM

However, the configuration of Patent Document 1 has a problem where two or more points on a display screen cannot be detected at the same time. Moreover, in the configuration of Patent Document 2, as illustrated in FIG. 20 which is a view illustrating touch positions (pressed positions), when two points, for example, point A (a, c) and point B (b, d) in an X-Y coordinate are touched and pressed at the same time, point C (a, d) and point D (b, c) may be erroneously detected as the touched points. Moreover, when point C and point D are touched with point A and point B being touched, point C and point D cannot be detected. Therefore, the configuration of Patent Document 2 also has a problem where simultaneously detecting two or more points at a high accuracy is difficult.

Moreover, in the configuration of Patent Document 3, a detection circuit for detecting a pressed position has to be inspected for a failure such as disconnection after a first substrate on which the detection circuit and the sensing unit inspection lines are formed is adhered to a second substrate on which the inspection spacers are formed. Therefore, if a failure is found in the detection circuit as a result of the inspection, the entirety of the first substrate and the second substrate which are adhered to each other has to be discarded, which leads to a problem where the rate of wasted parts increases.

In view of the foregoing, the present invention was devised. It is an objective of the present invention to provide a display device in which a plurality of pressed positions can be detected at a high accuracy, and the rate of parts discarded as a result of the inspection is reduced to reduce production cost.

### SOLUTION TO THE PROBLEM

To achieve the objective, the present invention is intended for a display device including a first substrate, a second substrate arranged to face the first substrate, where a counter electrode is formed on the second substrate, and a plurality of pixels formed on the first substrate, where a pixel electrode facing the counter electrode and a switching element connected to the pixel electrode are formed in each pixel.

The display device includes: detection sections each of which is arranged in an associated one of the pixels, and is configured to detect a position in which the first substrate or the second substrate is pressed; a plurality of scan lines and a plurality of detection lines formed on the first substrate, and connected to the detection sections; a scan driver formed on the first substrate, connected to the scan lines, and configured to sequentially supply a scan voltage to the scan lines; and a detection driver formed on the first substrate, and connected to the detection lines, wherein the detection driver is configured such that when an area of the first substrate or the second substrate is pressed, and the detection section in the pressed area is scanned with the scan line, a voltage applied to the detection section is detected via the detection line connected to the detection section, and an inspection line is formed on the first substrate, where at least the scan lines or the detection lines are connected to the inspection line in parallel, and an inspection signal is input from or output to the inspection line.

### -Operation-

Next, operation of the present invention will be described.

In the present invention, the display device drives the pixel electrode of each pixel by the switching element to generate a predetermined potential difference between the pixel electrode and the counter electrode, thereby displaying an image.

The detection sections each arranged in associated one of the pixels are scanned by sequentially supplying with a scan voltage from the scan driver. When the first substrate or the second substrate of the display device is pressed, and the detection section in the pressed area is scanned, the voltage applied to the detection section is detected by the detection driver via the detection line connected to the detection section. The pressed position on the display device is thus detected.

Moreover, the detection section is provided each pixel, and the scan line and the detection line are connected to each detection section. Thus, a plurality of pressed positions can be simultaneously detected at a high accuracy.

Here, for example, when the plurality of scan lines are connected to the inspection line in parallel, an inspection signal input to the scan lines is output to the inspection line connected to the scan lines in a process for fabricating the display device, so that the output signal of each scan line is sequentially detected, which makes it possible to detect disconnection or an interconnect resistance failure of each scan line.

In contrast, when the plurality of detection lines are connected to the inspection line in parallel, an inspection signal input to the inspection line is input to the detection lines connected to the inspection line in a process for fabricating the display device, so that the input signal is detected by each detection line, which makes it possible to detect disconnection or an interconnect resistance failure of each detection line.

Therefore, according to the present invention, sequentially scanning the scan lines allows the detection sections to detect a plurality of pressed positions (touch positions) at a high accuracy. In addition, in a process for fabricating the display device, interconnects of the first substrate can be inspected before the first substrate is adhered to the second substrate. Thus, a second substrate having no failure is no longer discarded, which can reduce the rate of parts wastefully discarded as a result of the inspection to reduce fabrication cost.

### ADVANTAGES OF THE INVENTION

According to the present invention, the detection sections each provided to an associated one of the pixels can detect a plurality of pressed positions at a high accuracy. In addition, the inspection line is formed on the first substrate, where at least the plurality of scan lines or the plurality of detection lines are connected to the inspection line in parallel, and an inspection signal is output to or input from the inspection line. Thus, when the scan lines and the detection lines are inspected, it is no longer necessary to wastefully discard a second substrate, which can significantly reduce production cost.

### BRIEF DESCRIPTION OF THE DRAWINGS

[FIG. 1] FIG. 1 is a plan view schematically illustrating a circuit configuration of a TFT substrate included in a liquid crystal display device of the first embodiment.
[FIG. 2] FIG. 2 is a plan view schematically illustrating a counter substrate included in the liquid crystal display device of the first embodiment.
[FIG. 3] FIG. 3 is a circuit diagram illustrating an enlargement of a pixel of the liquid crystal display device of the first embodiment.
[FIG. 4] FIG. 4 is a cross-sectional view schematically illustrating a structure of the liquid crystal display device of the first embodiment.
[FIG. 5] FIG. 5 is a cross-sectional view illustrating an enlargement of part of the counter substrate of the first embodiment.
[FIG. 6] FIG. 6 is a waveform diagram illustrating a voltage supplied to each of scan lines.
[FIG. 7] FIG. 7 is a view illustrating touched positions and outputs of detection lines detected based on the touched positions.
[FIG. 8] FIG. 8 is a circuit diagram illustrating a system for detecting a pressed position of the first embodiment.
[FIG. 9] FIG. 9 is a waveform diagram illustrating input/output voltages of the detection system in one scan period of the first embodiment.
[FIG. 10] FIG. 10 is a plan view schematically illustrating the circuit configuration of the TFT substrate in a fabrication process.
[FIG. 11] FIG. 11 is a timing diagram illustrating an inspection signal input to the scan lines, and the inspection signal output to an inspection line.
[FIG. 12] FIG. 12 is a plan view schematically illustrating a circuit configuration of a TFT substrate included in a liquid crystal display device of a second embodiment.
[FIG. 13] FIG. 13 is a plan view schematically illustrating a counter substrate included in the liquid crystal display device of the second embodiment.
[FIG. 14] FIG. 14 is a plan view schematically illustrating the circuit configuration of the TFT substrate in a fabrication process.
[FIG. 15] FIG. 15 is a timing diagram illustrating an inspection signal input to an inspection line, and the inspection signal output to detection lines.
[FIG. 16] FIG. 16 is a plan view schematically illustrating a circuit configuration of a TFT substrate included in a liquid crystal display device of a third embodiment.
[FIG. 17] FIG. 17 is a plan view schematically illustrating a circuit configuration of a TFT substrate included in a liquid crystal display device of a fourth embodiment.
[FIG. 18] FIG. 18 is a plan view schematically illustrating a circuit configuration of a TFT substrate included in a liquid crystal display device of a fifth embodiment.
[FIG. 19] FIG. 19 is a cross-sectional view schematically illustrating a structure of the liquid crystal display device of the fifth embodiment.
[FIG. 20] FIG. 20 is a view illustrating touched positions of a conventional display device.

### DESCRIPTION OF EMBODIMENTS

Embodiments of the present invention will be described in detail below with reference to the drawings. The present invention is not limited to the embodiments below.

### «First Embodiment of Invention>>

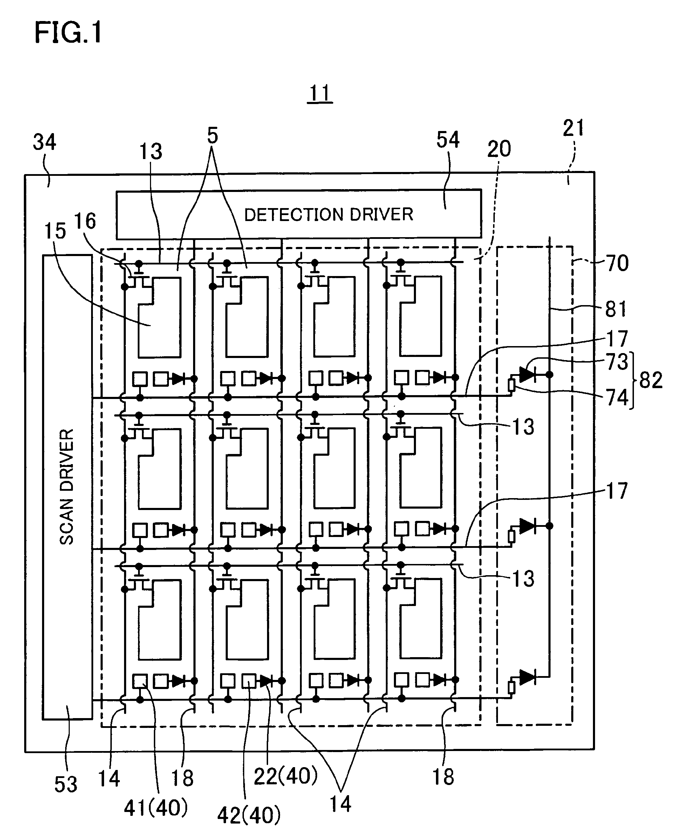

FIGS. 1-11 are views illustrating a first embodiment of the invention.

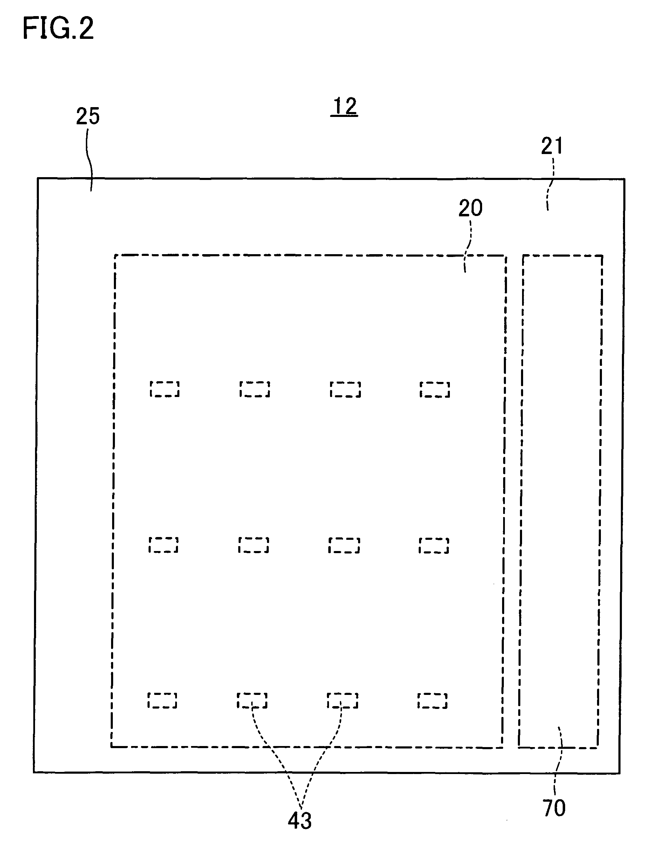

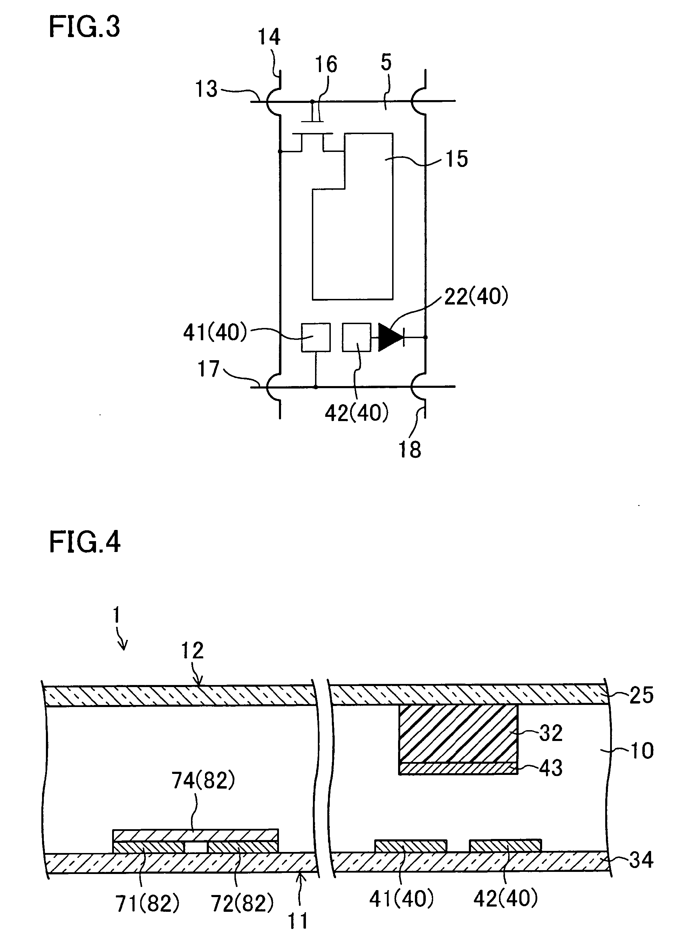

FIG. 1 is a plan view schematically illustrating a circuit configuration of a TFT substrate 11 included in a liquid crystal display device 1 of the first embodiment. FIG. 2 is a plan view schematically illustrating a counter substrate 12 included in the liquid crystal display device 1 of the first embodiment. FIG. 3 is a circuit diagram illustrating an enlargement of one of pixels 5 of the liquid crystal display device 1 of the first embodiment.

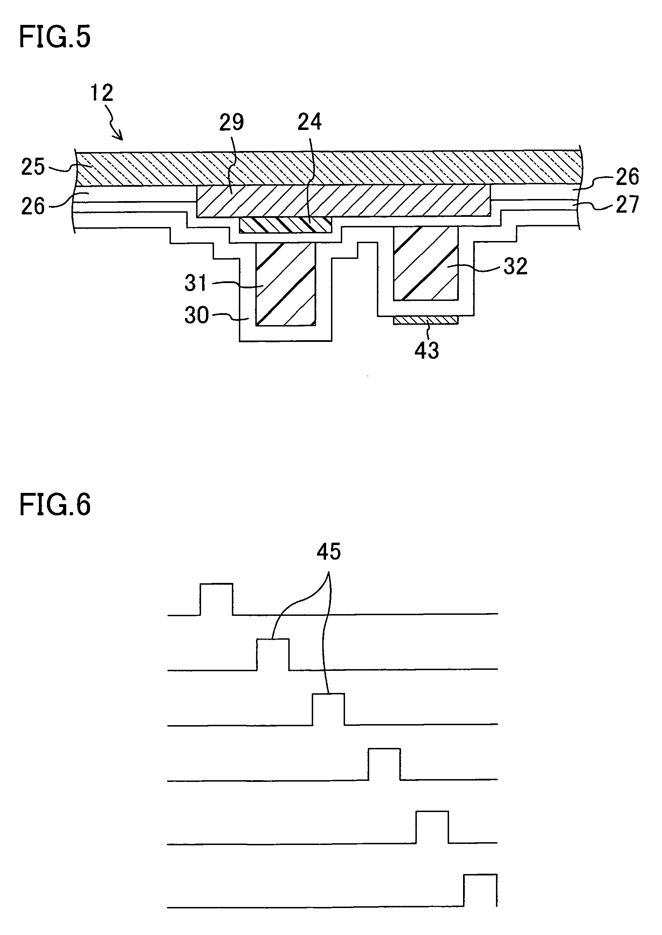

Moreover, FIG. 4 is a cross-sectional view schematically illustrating a structure of the liquid crystal display device 1 of the first embodiment. FIG. 5 is a cross-sectional view illustrating an enlargement of part of the counter substrate 12 of the first embodiment. FIG. 6 is a waveform diagram illustrating a voltage supplied to each of scan lines 17.

### -Configuration of Liquid Crystal Display Device-

In the first embodiment, a liquid crystal display device is described as an example. The liquid crystal display device 1 of the first embodiment is configured, for example, as a transparent-type liquid crystal display device for transparent display.

As illustrated in FIG. 4, the liquid crystal display device 1 includes the TFT substrate 11 serving as a first substrate, the counter substrate 12 serving as a second substrate arranged to face the TFT substrate 11, and a liquid crystal layer 10 provided between the counter substrate 12 and the TFT substrate 11. As illustrated in FIG. 1, the liquid crystal display device 1 includes a display area 20 which is, for example, in a rectangular shape, and a frame area 21 which serves as a non-display area, and is formed in a frame shape around the display area 20.

### (Configuration of Counter Substrate)

As illustrated in FIG. 5, the counter substrate 12 includes a glass substrate 25 having a thickness of, for example, 0.7 mm or smaller, a color filter layer 26 formed on the glass substrate 25 to face the liquid crystal layer 10, a black matrix 29 serving as a light-shielding film, and a counter electrode (common electrode) 27. A spacer seat section 24 is formed on part of a surface of the black matrix 29. The spacer seat section 24 and a colored layer of the color filter layer 26 are made of the same material, and have the same thickness.

The counter electrode 27 includes a transparent conductive film such as, for example, indium tin oxide (ITO), and is uniformly formed almost entirely over the display area 20. The spacer seat section 24, the color filter layer 26, and the black matrix 29 are covered with the counter electrode 27 formed by vapor deposition of the ITO.

On a surface of the counter electrode 27, a pillar-shaped spacer 31 for setting the thickness of the liquid crystal layer 10 (so-called cell gap) is formed by photolithography in an area in which the spacer seat section 24 is provided. Moreover, on the surface of the counter electrode 27, touch sensor projections 32 are formed in the area in which the black matrix 29 is formed.

The touch sensor projections 32 and the pillar-shaped spacer 31 are made of the same photosensitive material, and have the same length. The touch sensor projections 32 are formed by photolithography at the same time when the pillar-shaped spacer 31 is formed.

Since the spacer seat section 24 is disposed between the pillar-shaped spacer 31 and the black matrix 29, a tip of the pillar-shaped spacer 31 is arranged closer to the TFT substrate 11 than tips of the touch sensor projections 32 are.

On the surface of the counter electrode 27 facing the liquid crystal layer 10, an alignment layer 30 is formed to cover the pillar-shaped spacer 31 and the touch sensor projections 32. The alignment layer 30 is made of, for example, polyimide. Note that in FIG. 4, the alignment layer 30 is not illustrated. Moreover, a deflecting plate which is not illustrated is adhered to a surface of the glass substrate 25 opposite to the liquid crystal layer 10.

### (Configuration of TFT Substrate)

As illustrated in FIG. 1, the TFT substrate 11 is configured as a so-called active matrix substrate. As illustrated in FIG. 4, the TFT substrate 11 includes a glass substrate 34 having a thickness of, for example, 0.7 mm or smaller. As illustrated in FIG. 1, a plurality of gate lines 13 serving as scan interconnects and extending parallel to each other are formed on the TFT substrate 11.

Moreover, a plurality of source lines 14 serving as signal interconnects and extending to cross the gate lines 13 are formed on the TFT substrate 11. In this way, on the TFT substrate 11, interconnects including the gate lines 13 and the source lines 14 are formed in a matrix pattern.

As illustrated in FIG. 1, each pixel 5 is formed, for example, by a rectangular area partitioned by the gate lines 13 and the source lines 14. That is, the plurality of pixels 5 arranged in a matrix pattern are formed in the display area 20 of the TFT substrate 11.

Each pixel 5 includes a pixel electrode 15 facing the counter electrode 27, and a thin film transistor (TFT) 16. The TFT 16 serves as a switching element connected to the pixel electrode 15 to drive the liquid crystal layer 10 by switching.

The TFT 16 is arranged, for example, at an upper left comer in the pixel 5 in FIGS. 1 and 3, and includes a gate electrode (not shown) connected to the gate line 13, a source electrode (not shown) connected to the source line 14, and a drain electrode (not shown) connected to the pixel electrode 15. That is, the gate line 13 and the source line 14 are connected to the TFT 16.

In the frame area 21 of the TFT substrate 11, a gate driver (not shown) connected to the gate lines 13, a source driver (not shown) connected to the source lines 14, a scan driver 53 connected to the scan lines 17 which will be described later, and a detection driver 54 connected to detection lines 18 which will be described later are provided along respective sides of the TFT substrate 11.

Here, a scan voltage is applied from the gate driver (not shown) to the gate electrodes (not shown) of the TFTs 16 via the gate lines 13. In this state, a signal voltage is supplied from the source driver (not shown) to the pixel electrodes 15 via the source lines 14, and the source electrodes (not shown) and the drain electrodes (not shown) of the TFTs 16. In this way, the liquid crystal layer 10 is driven by potential difference produced between the counter electrode 27 and the pixel electrodes 15, thereby displaying a desired image.

### (Detection Section)

As illustrated in FIGS. 1 and 3, detection sections 40 each of which is arranged in an associated one of the pixels 5, and is configured to detect a position in which the TFT substrate 11 or the counter substrate 12 is pressed are formed on the TFT substrate 11. Each detection section 40 includes detection electrodes 41, 42 electrically insulated from the pixel electrode 15, and a detection element 22 connected to the detection electrode 42.

The detection electrodes 41, 42 respectively include a first electrode 41 and a second electrode 42 which are arranged in alignment with each other, but are electrically insulated from each other. The detection element 22 of the first embodiment is connected to the second electrode 42.

### (Detection electrode)

That is, as illustrated in FIGS. 1, 3, and 4, the TFT substrate 11 includes the plurality of first electrodes 41 and the plurality of second electrodes 42 which are formed on the glass substrate 34, where the second electrodes 42 are electrically insulated from the first electrodes 41, and are arranged in alignment with the first electrodes 41. In the first embodiment, a pair of the first electrode 41 and the second electrode 42 is arranged in each pixel 5.

The first electrode 41 and the second electrode 42 are made of the same material as the pixel electrode 15, which is for example, ITO, and each have a smaller size than the pixel electrode 15. The pixel electrode 15 is covered with the alignment layer (not shown), while the first electrode 41 and the second electrode 42 are not covered with the alignment layer (not shown), and are exposed.

### (Scan Line and Detection Line)

Moreover, as illustrated in FIGS. 1 and 3, the plurality of scan lines 17 and the plurality of detection lines 18 connected to the detection sections 40 are formed on the TFT substrate 11. The scan lines 17 are formed along the gate lines 13, whereas the detection lines 18 are formed along the source lines 14. That is, these scan lines 17 and the detection lines 18 are formed in a matrix pattern as a whole.

### (Detection element)

As illustrated in FIG. 3, the first electrode 41 is connected to the scan line 17, whereas the second electrode 42 is connected to the detection line 18 via a thin film diode (TFD) 22 serving as the detection element 22. The TFD 22 allows a flow of a current from the second electrode 42 toward the detection line 18.

Although the first embodiment describes an example in which the TFD 22 is provided between the second electrode 42 and the detection line 18, the present invention is not limited to this example. A TFD 22 allowing a flow of a current from the scan line 17 to the detection line 18 may be provided to at least one of the first electrode 41 and the scan line 17 or the second electrode 42 and the detection line 18. In other words, it is possible to configure the detection element 22 to be connectable to the first electrode 41 or the second electrode 42.

### (Conductive Layer)

As illustrated in FIGS. 2, 4, and 5, a plurality of conductive layers 43 are formed on the counter substrate 12. Each of the conductive layers 43 is arranged in an associated one of the pixels 5 to face both the first electrode 41 and the second electrode 42. The plurality of conductive layers 43 are electrically insulated from each other. Moreover, the conductive layers 43 are electrically insulated from the counter electrode 27.

The conductive layers 43 are formed on the tips of the touch sensor projections 32 (to face the TFT substrate 11), are not covered with the alignment layer 30, and are exposed. For example, the conductive layers 43 are made of ITO, or the like vapor-deposited on the alignment layer 30. Note that the conductive layers 43 can be made of, for example, a resin having conductivity.

### (Scan Driver and Detection Driver)

As illustrated in FIG. 1, the scan driver 53 connected to the plurality of scan lines 17 is formed in the frame area 21 of the TFT substrate 11. The scan driver 53 is configured as a voltage supply section for sequentially applying a scan voltage to the first electrodes 41 via the scan lines 17.

The detection driver 54 connected to the plurality of detection lines 18 is formed in the frame area 21 of the TFT substrate 11. The detection driver 54 is configured such that when the TFT substrate 11 or the counter substrate 12 is pressed to bring the conductive layer 43 into contact with both the first electrode 41 and the second electrode 42, and the detection section 40 in the pressed area is scanned with the scan line 17, the voltage applied to the first electrode 41 of the detection section 40 is detected via the detection line 18 connected to the detection section 40.

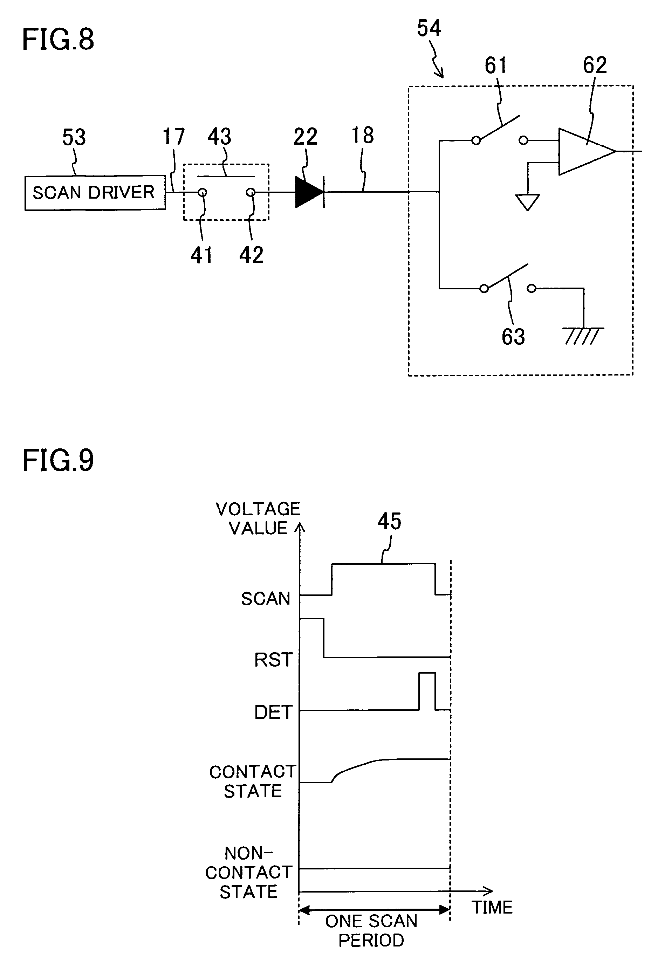

As illustrated in FIG. 8, the detection driver 54 includes a comparator circuit section 62 connected to the detection line 18 via a DET switch 61, and a RST switch 63 connected to the detection line 18, where the RST switch 63 and the DET switch 61 are in parallel. Moreover, an input of the comparator circuit section 62 is connected to a reference voltage source.

When the DET switch 61 is turned on, the DET switch 61 connects the detection line 18 to the comparator circuit section 62. When the RST switch 63 is turned on, the RST switch 63 electrically connects the detection line 18 to ground.

### (Inspection Circuit)

An inspection circuit 70 by which a circuit for detecting a pressed position is inspected for a failure is formed in the frame area 21 of the TFT substrate 11.

On the TFT substrate 11 of the first embodiment, the inspection circuit 70 for detecting disconnection or a resistance failure of the scan lines 17 is formed on a side opposite to the scan driver 53 with the display area 20 provided between the inspection circuit 70 and the scan driver 53. The inspection circuit 70 includes an inspection line 81 to which the plurality of scan lines 17 are connected in parallel, and an inspection signal is output, and circuit sections 82 provided between the inspection line 81 and the scan lines 17.

Note that as described later, the inspection line 81 to which at least the plurality of scan lines 17 or the plurality of detection lines 18 are connected in parallel, and to/from which an inspection signal is output/input may be formed on the TFT substrate 11. Moreover, the circuit sections 82 may be provided between the inspection line 81 and the scan lines 17 or between the inspection line 81 and the detection lines 18.

As illustrated in FIG. 4, each circuit section 82 includes a first dummy electrode 71 having an identical configuration to the first electrode 41, a second dummy electrode 72 having an identical configuration to the second electrode 42, and a dummy element 73 having an identical configuration to the TFD 22 serving as the detection element.

That is, each of the first dummy electrode 71 and the second dummy electrode 72 is made of a transparent conductive film such as ITO. Moreover, the dummy element 73 of the first embodiment is made of TFD. The first dummy electrode 71 and the second dummy electrode 72 are electrically connected to each other via a connection portion 74 made of a conductive layer.

### -Method for Detecting Pressed Position-

Next, a method for detecting a pressed position by using the liquid crystal display device 1 will be described.

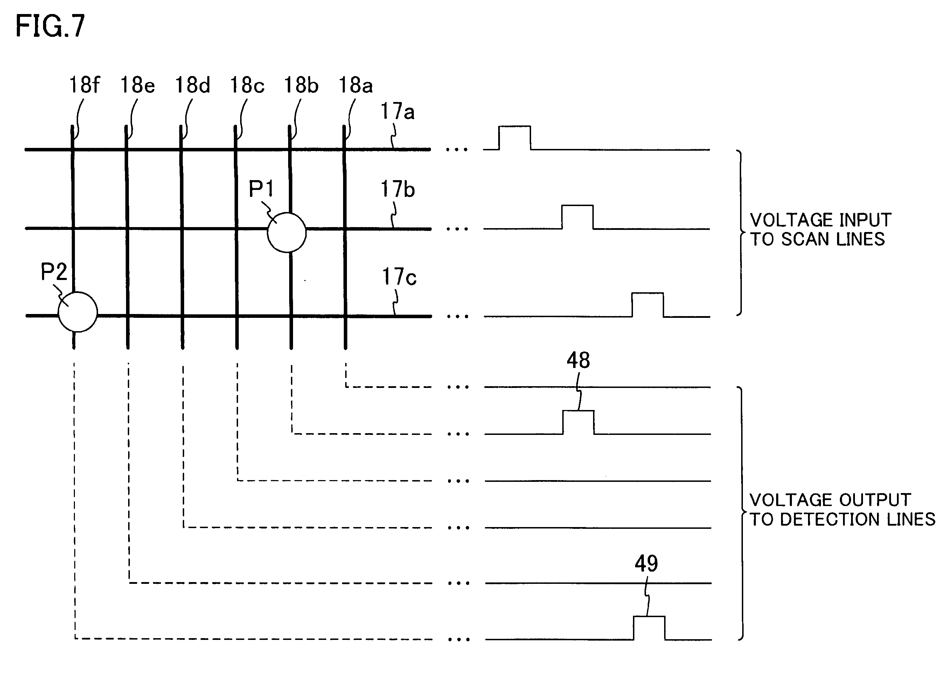

Here, FIG. 7 is a view illustrating positions pressed by touching, and outputs of the detection lines 18 which are detected based on the positions. FIG. 8 is a circuit diagram illustrating a pressed position detection system of the first embodiment. FIG. 9 is a waveform diagram illustrating voltages input/output by the detection system in one scan period of the first embodiment.

When the TFT substrate 11 or the counter substrate 12 is pressed by touching, the pressed substrate curves in the pressed direction, and the conductive layer 43 formed on the counter substrate 12 is brought into contact with both the first electrode 41 and the second electrode 42 formed on the TFT substrate 11. This establishes conduction between the first electrode 41 and the second electrode 42 via the conductive layer 43.

As illustrated in FIG. 6, the scan lines 17 in rows in the entirety of the display area 20 are sequentially scanned, and are supplied with a Hi voltage (scan voltage) 45 from the scan driver 53.

As illustrated in FIGS. 8 and 9, before the Hi voltage 45 is supplied to the scan line 17 in a row, the detection driver 54 turns off the DET switch 61 connected to the detection line 18, and turns on the RST switch 63 to remove charge from the detection line 18 in advance, thereby resetting the detection line 18. After that, the RST switch 63 is turned off, and scanning the scan line 17 is started.

Here, in FIG. 9, the horizontal axis indicates time, and the vertical axis indicates the level of a voltage value. Moreover, one scan period means a period in which a series of processes is performed on the scan line 17 in one row.

When a Hi voltage 45 is supplied to the scan line 17 in one row for which the scanning is started, the Hi voltage 45 is supplied simultaneously to the first electrodes 41 connected to the scan line 17. Here, when the TFT substrate 11 or the counter substrate 12 is pressed by toughing, and conduction from any of the first electrodes 41 to the second electrode 42 is established via the conductive layer 43, the Hi voltage 45 of the first electrode 41 in the pressed position is supplied to the detection line 18 via the conductive layer 43 and the second electrode 42.

Here, the voltage value supplied to the detection line 18 gradually increases as illustrated in FIG. 9. The voltage sufficiently supplied to the detection line 18 is supplied to the comparator circuit section 62, and is subjected to AD conversion by turning on the DET switch 61, as a result of which the voltage is detected by the detection driver 54.

In contrast, when the substrate is not touched on the scan line 17 of one row for which the scanning is started, the Hi voltage 45 of the first electrode 41 is not supplied to the detection line 18, and as illustrated in FIG. 9, the Hi voltage 45 is not detected by the detection driver 54. In other words, a non-contact state is detected by the detection driver 54.

A series of the above-described processes is performed on each scan line 17. In this way, a pressed position over the entirety of the display area 20 is detected.

Here, with reference to FIG. 7, position detection in the case where two points are touched at the same time will be described.

In FIG. 7, scan lines 17a-17c are arranged in the row direction, and detection lines 18a-18f are arranged in the column direction. At point P1 and point P2, the TFT substrate 11 or the counter substrate 12 is pressed by touching.

Point P1 is in the vicinity of a pair of electrodes 41, 42 including a first electrode 41 connected to the scan line 17b and a second electrode 42 connected to the detection line 18b. Point P2 is in the vicinity of a pair of electrodes 41, 42 including a first electrode 41 connected to the scan line 17c and a second electrode 42 connected to the detection line 18f.

In FIG. 7, the scan lines 17a-17c are scanned from an upper row. First, when the scan line 17a is scanned, a voltage value is not detected on the detection lines 18a-18f. Next, when the scan line 17b is scanned, a voltage 48 supplied to the first electrode 41 is detected via the detection line 18b because conduction is established between the first electrode 41 and the second electrode 42 via the conductive layer 43 at point P1.

Next, when the scan line 17c is scanned, a voltage 49 supplied to the first electrode 41 is detected via the detection line 18f because conduction is established between the first electrode 41 and the second electrode 42 via the conductive layer 43 at point P2. As a result, detection of point P1 and point P2 is ensured.

### -Fabrication Method and Inspection Method-

Next, methods for fabricating and inspecting the liquid crystal display device 1 will be described.

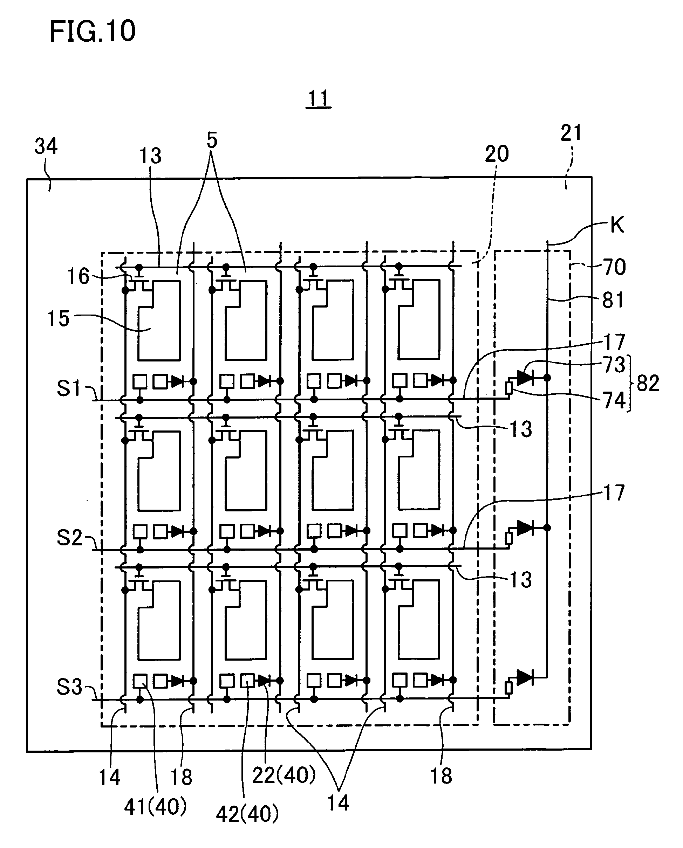

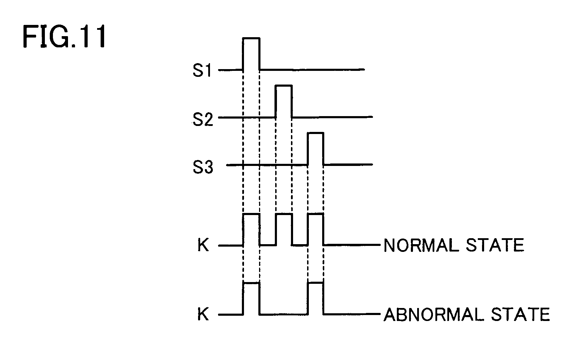

Here, FIG. 10 is a plan view schematically illustrating the circuit configuration of the TFT substrate 11 in a fabrication process. FIG. 11 is a timing diagram illustrating an inspection signal input to the scan lines 17, and the inspection signal output to the inspection line 81.

The liquid crystal display device 1 is fabricated by forming a frame-like sealing member (not shown) on the TFT substrate 11 or the counter substrate 12, dropping liquid crystal inside the sealing member, and then adhering the TFT substrate 11 and the counter substrate 12 to each other.

In particular, in the process of forming the TFT substrate 11, the inspection line 81 is formed in the same process as that to form the detection lines 18 at the same time as the detection lines 18. Moreover, the first electrodes 41, the second electrodes 42, the first dummy electrodes 71, and the second dummy electrodes 72 are formed in the same process as that to form the pixel electrodes 15 at the same time as the pixel electrodes 15. Furthermore, the dummy elements 73 are formed in the same process as that to form the TFDs 22 at the same time as the TFDs 22.

In the process of inspecting the scan lines 17 serving as a circuit for detecting a pressed position on the TFT substrate 11, a Hi voltage serving as an inspection signal is first sequentially applied to the plurality of scan lines 17 in a manner similar to that performed to normally detect a pressed position. For example, as illustrated in FIGS. 10 and 11, a pulsed inspection signal is sequentially applied to terminals S1, S2, S3 of the scan lines 17. Here, each of the scan lines 17 outputs the inspection signal to the inspection line 81 via the circuit section 82.

That is, as illustrated in FIG. 11, when each scan line 17 is in a normal state, the inspection signal is output to and detected at a terminal K of the inspection line 81 in response to the input of the inspection signal to the terminals S1, S2, S3 of the scan lines 17. In contrast, for example, when the scan line 17 having the terminal S2 has a failure, the inspection signal is not detected at the terminal K of the inspection line 81, or an inspection signal having a voltage value different from that obtained in the normal state is detected at timing corresponding to the input of the inspection signal to the terminal S2.

In this way, when the inspection signal is normally detected at the terminal K of the inspection line 81, it can be seen that each scan line 17 is in a normal state. In contrast, at the terminal K, when the inspection signal is not detected, or when an inspection signal having a voltage value different from that obtained in the normal state is detected, it can be seen that the scan line 17 to which the inspection signal has been input at the timing corresponding to the detection timing has a failure.

After the inspection process, the TFT substrate 11 whose scan lines 17 are in the normal state is adhered to the counter substrate 12 via the liquid crystal layer 10, thereby forming the liquid crystal display device 1. In contrast, the TFT substrate 11 whose scan lines 17 have a failure is discarded, or the failure is repaired if possible.

### -Advantages of First Embodiment-

Therefore, according to the first embodiment, a plurality of pressed positions can be detected at a high accuracy by the detection sections 40 each provided in associated one of the pixels 5. In addition, the inspection line 81 to which the plurality of scan lines 17 are connected in parallel, and the inspection signal is output is formed on the TFT substrate 11, and thus when the scan lines 17 are inspected, it is no longer necessary to wastefully discard counter substrates 12. This can significantly reduce fabrication cost.

That is, first, the conductive layer 43 facing the electrodes 41, 42 and the TFD 22 are provided to each pair of the first electrode 41 and the second electrode 42 which are disposed in alignment with each other, the voltage of the scan driver 53 is supplied to the first electrodes 41 via the plurality of scan lines 17, and the voltage supplied to the first electrode 41 at a pressed position is detected by the detection driver 54 via the conductive layer 43, the second electrode 42, and the detection line 18. Thus, sequentially scanning the scan lines 17 eliminates erroneous detection even when two or more points are touched at the same time, and allows each pair of the first electrode 41 and the second electrode 42 to detect the pressed position at a high accuracy.

Moreover, the scan lines 17 and the detection lines 18 are provided independently of the gate lines 13 and the source lines 14. Thus, pressed positions can be detected at all times independently of control of display by the gate lines 13 and the source lines 14, which can further increase the detection accuracy.

In addition, the plurality of scan lines 17 are connected to the inspection line 81 in parallel via the circuit sections 82. Thus, in the process of inspecting the TFT substrate 11, an inspection signal is sequentially input to the scan lines 17, so that if timing at which the inspection signal is not output to the inspection line 81 is found, or the inspection signal output to the inspection line 81 does not reach a predetermined voltage, a failure such as disconnection or too large interconnect resistance of the scan line 17 corresponding to the timing can be detected.

When a failure of the scan line 17 remains in a completed liquid crystal display device 1, a linear area in which a pressed position cannot be detected is formed along the scan line 17, so that the liquid crystal display device 1 cannot be a product for sale.

In conventional liquid crystal display devices, a failure is first found in an inspection performed after the TFT substrate 11 and the counter substrate 12 are adhered to each other, whereas in the present embodiment, the TFT substrate 11 can be inspected before the substrates are adhered to each other. Thus, a defective TFT substrate 11 is not adhered to a non-defective counter substrate 12, so that fabrication cost can be significantly reduced.

Moreover, in the present embodiment, each circuit section 82 which is a dummy and has a circuit configuration similar to that of the actual detection section 40 is provided between the scan line 17 and the inspection line 81. Thus, under the same condition as that for driving the actual detection section 40 to detect a pressed position, the waveform of an inspection signal can be inspected, so that an interconnect resistance failure of the scan line 17 can also be inspected at a high accuracy.

Moreover, in normal operation of the completed liquid crystal display device 1, an output of the inspection line 81 is ignored, and is not used for any control, so that crystal liquid display and detection of a pressed position can be performed normally.

### «Second Embodiment of Invention>>

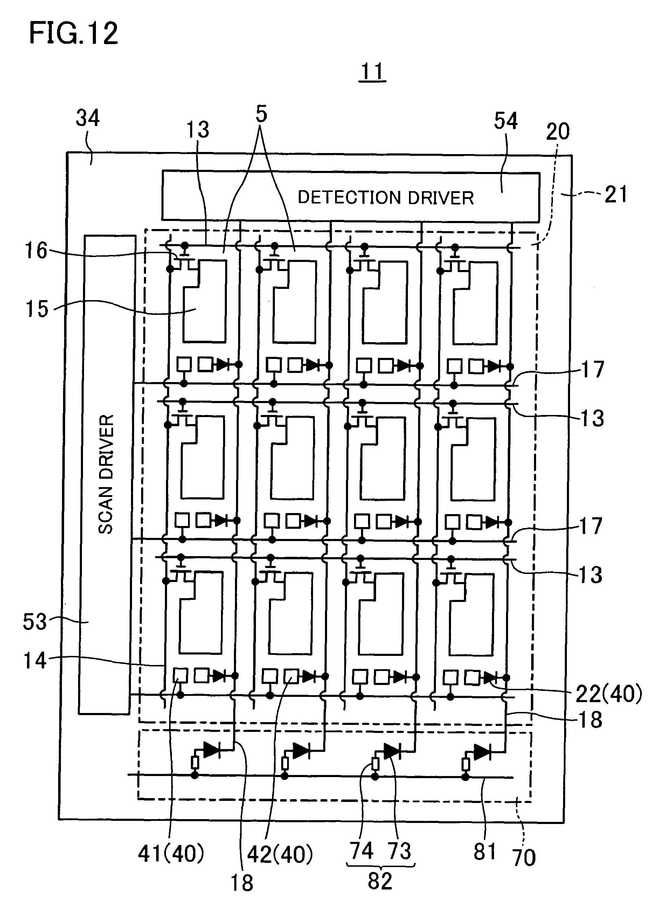

FIGS. 12-15 are views illustrating a second embodiment of the present invention.

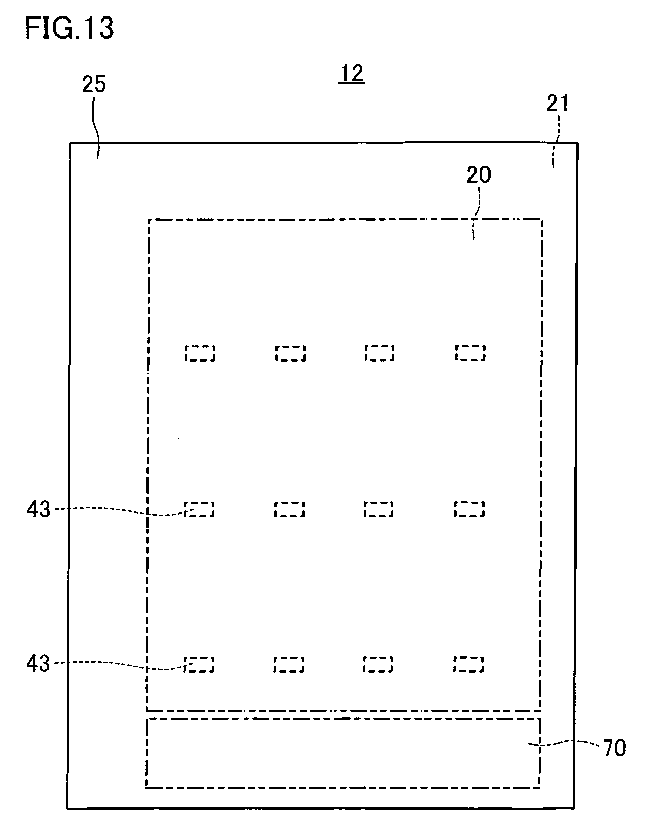

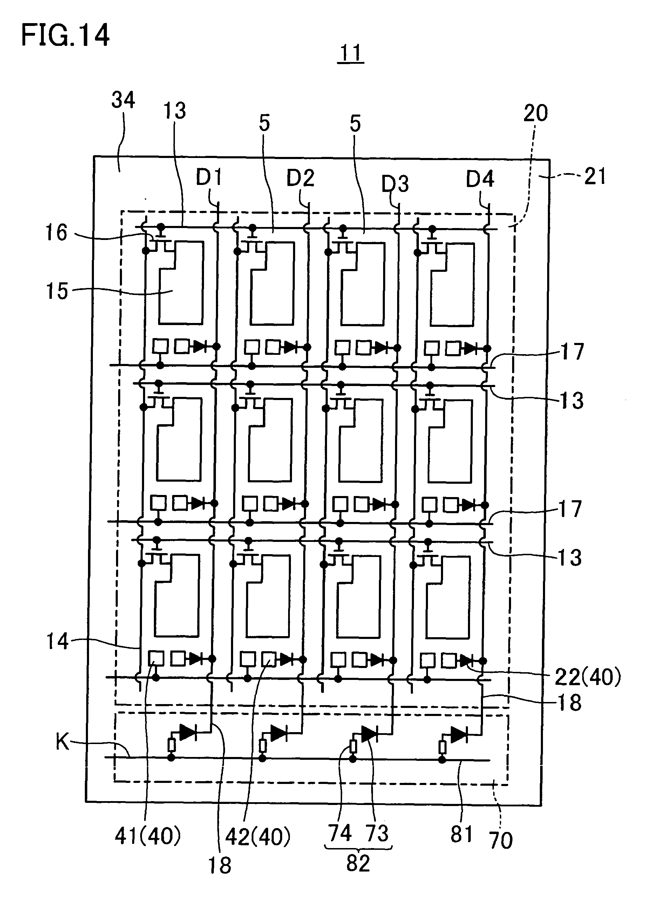

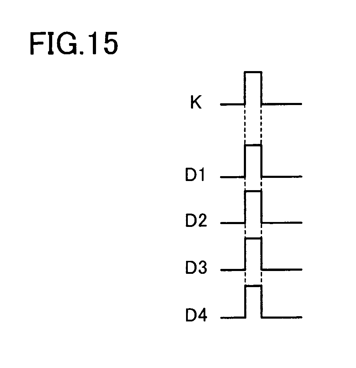

FIG. 12 is a plan view schematically illustrating a circuit configuration of a TFT substrate 11 included in a liquid crystal display device 1 of the second embodiment. FIG. 13 is a plan view schematically illustrating a counter substrate 12 included in the liquid crystal display device 1 of the second embodiment. FIG. 14 is a plan view schematically illustrating the circuit configuration of the TFT substrate 11 in a fabrication process. FIG. 15 is a timing diagram illustrating an inspection signal input to an inspection line 81, and the inspection signal output to detection lines 18.

Note that in the embodiments below, the same reference numerals as those shown in FIGS. 1-11 are used to represent equivalent elements, and the detailed explanation thereof is omitted.

The inspection circuit 70 of the first embodiment is connected to the plurality of scan lines 17, whereas an inspection circuit 70 of the second embodiment is connected to the plurality of detection lines 18.

As illustrated in FIGS. 12 and 13, the inspection circuit 70 of the second embodiment is formed in a frame area 21 opposite to a detection driver 54 with a display area 20 provided between the inspection circuit 70 and the detection driver 54. The detection lines 18 are connected to the inspection line 81 in parallel via dummy circuit sections 82.

Similar to the first embodiment, each circuit section 82 has a configuration similar to that of the detection section 40, and includes: a TFD 73 which is the same as the detection element 22; and a first dummy electrode (not shown) and a second dummy electrode (not shown) which are connected to each other via a connection portion 74.

As illustrated in FIGS. 14 and 15, to inspect the TFT substrate 11 of the second embodiment, an inspection signal is input to a terminal K of the inspection line 81. In this case, if each detection line 18 does not have a failure such as disconnection, the inspection signal from the inspection line 81 is output via the circuit sections 82 from terminals D1, D2, D3, D4 of the detection lines 18. When it is detected that output values of the terminals are the same, it can be seen that the detection lines 18 are in a normal state.

In contrast, if any of the plurality of detection lines 18 has a failure, the inspection signal is not output from the terminal corresponding to the detection line 18 having the failure, or a value different from a normal value is output. In this way, it is possible to distinguish the detection line 18 having the failure.

### -Advantages of Second Embodiment-

Therefore, according to the second embodiment, advantages similar to those of the first embodiment can be obtained, and a plurality of pressed positions can be detected at a high accuracy. In addition, the inspection line 81 to which the plurality of detection lines 18 are connected in parallel and from which an inspection signal is output is formed on the TFT substrate 11, and thus when the detection lines 18 are inspected, it is no longer necessary to wastefully discard counter substrates 12. This can significantly reduce fabrication cost.

Moreover, in normal operation of a completed liquid crystal display device 1, an off-state voltage (Low voltage) which is input to the scan lines 17 in normal operation is applied to the inspection line 81 at all times so that the inspection circuit 70 does not perform its function. Thus, liquid crystal display and detection of a pressed position can be performed normally.

### «Third Embodiment of Invention>>

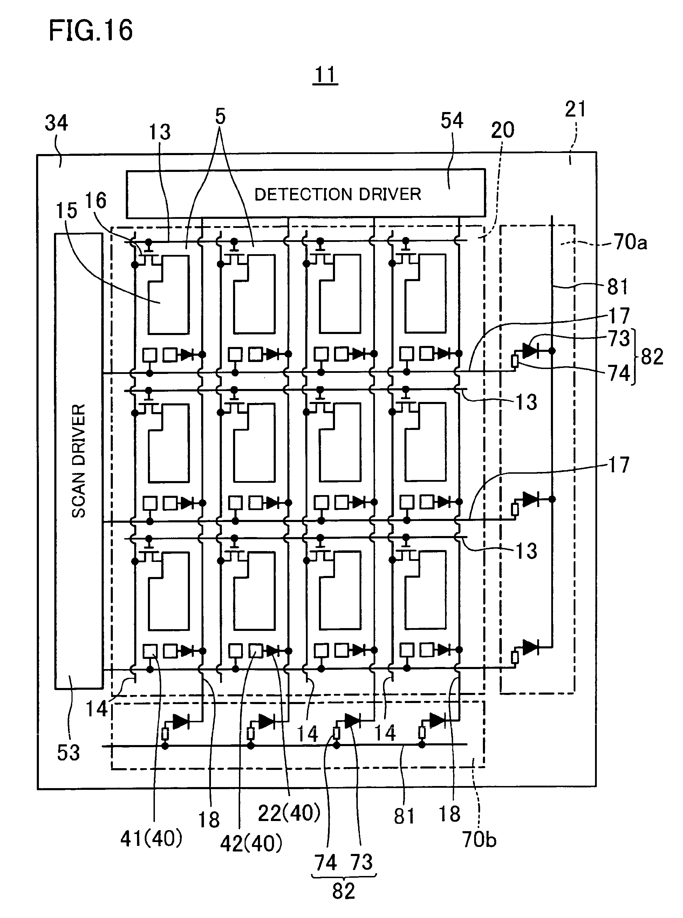

FIG. 16 illustrates a third embodiment of the invention.

FIG. 16 is a plan view schematically illustrating a circuit configuration of a TFT substrate 11 included in a liquid crystal display device 1 of the third embodiment.

The inspection circuit 70 of the first embodiment is connected to the plurality of scan lines 17, whereas inspection circuits 70 of the third embodiment are each connected to a plurality of scan lines 17 and a plurality of detection lines 18.

That is, as illustrated in FIG. 16, a first inspection circuit 70a is connected to the plurality of scan lines 17 in parallel, and a second inspection circuit 70b is connected to the plurality of detection lines 18 in parallel.

The first inspection circuit 70a has the same configuration as the inspection circuit 70 of the first embodiment. Moreover, the second inspection circuit 70b has the same configuration as the inspection circuit 70 of the second embodiment.

### -Advantages of Third Embodiment-

Therefore, according to the third embodiment, advantages similar to those of the first embodiment can be obtained. In addition, the plurality of scan lines 17 can be inspected by the first inspection circuit 70a in a manner similar to that performed in the first embodiment, and the plurality of detection lines 18 can be inspected by the second inspection circuit 70b in a manner similar to that performed in the second embodiment.

### «Fourth Embodiment of Invention>>

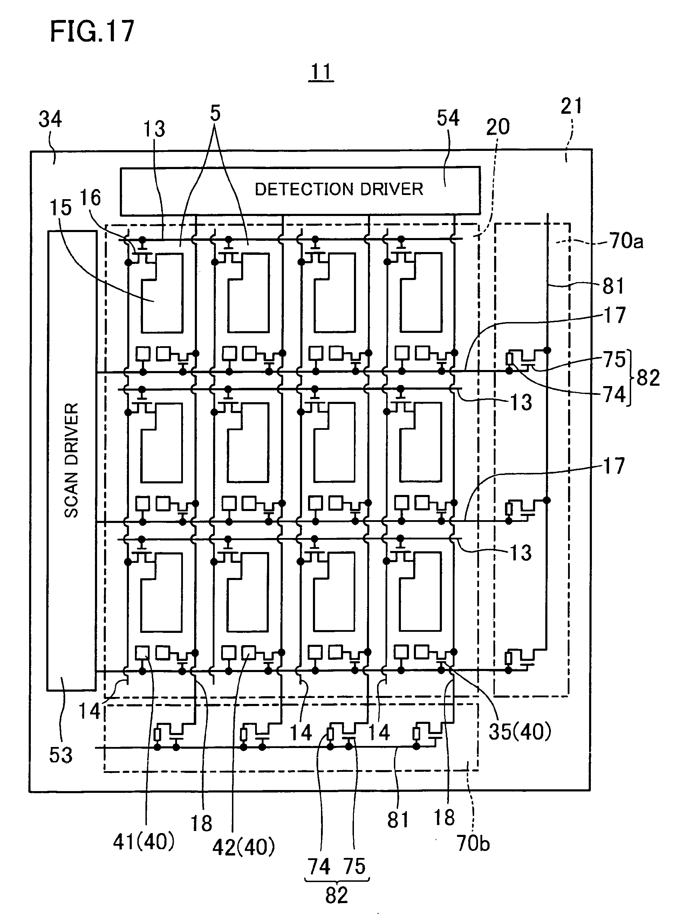

FIG. 17 illustrates a fourth embodiment of the present invention.

FIG. 17 is a plan view schematically illustrating a circuit configuration of a TFT substrate 11 included in a liquid crystal display device 1 of the fourth embodiment.

In the third embodiment, the detection element of each detection section 40 is made of the TFD 22, and the dummy element 73 of each circuit section 82 is made of the TFD 73. In contrast, in the fourth embodiment, a detection element of each of detection sections 40 is made of a TFT 35 serving as a thin film transistor, and a dummy element 73 of each of circuit sections 82 is made of a TFT 75. That is, also in the fourth embodiment, the dummy element 73 of the circuit section 82 has a configuration similar to that of the detection element 35 of the detection section 40.

To detect a pressed position, each of scan lines 17 is scanned to turn on the TFT 35 connected to the scan line 17, thereby allowing a flow of a current from a second electrode 42 toward a detection line 18. Thus, the pressed position can be detected in a manner similar to that performed in the first embodiment.

Likewise, to inspect the scan lines 17, an inspection signal is input to each scan line 17 to turn on the TFT 75 connected to the scan line 17, so that the scan lines 17 can be inspected in a manner similar to that performed in the first embodiment.

In contrast, to inspect the detection lines 18, an inspection signal is input to an inspection line 81 to turn on the TFTs 75 connected to the inspection line 81, thereby allowing a flow of a current from the inspection line 81 toward the detection lines 18. Thus, in a manner similar to that performed in the second embodiment, the detection lines 18 can be inspected.

### -Advantages of Fourth Embodiment-

Therefore, according to the fourth embodiment, advantages similar to those of the first embodiment can be obtained, and the plurality of scan lines 17 and the plurality of detection lines 18 can be inspected by first and second inspection circuits 70a, 70b in a manner similar to that performed in the third embodiment.

### <<Fifth Embodiment of Invention>>

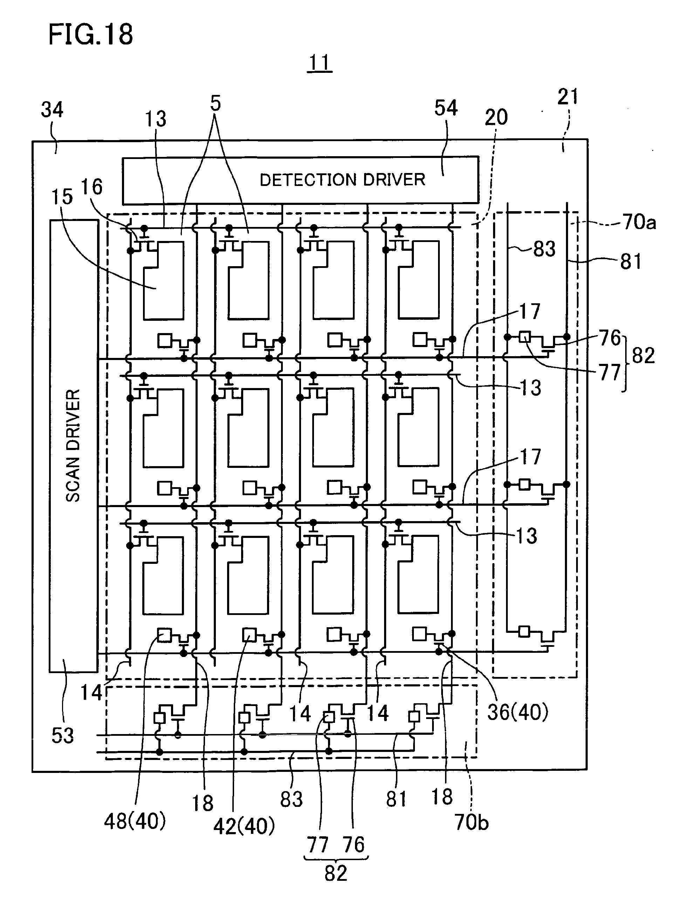

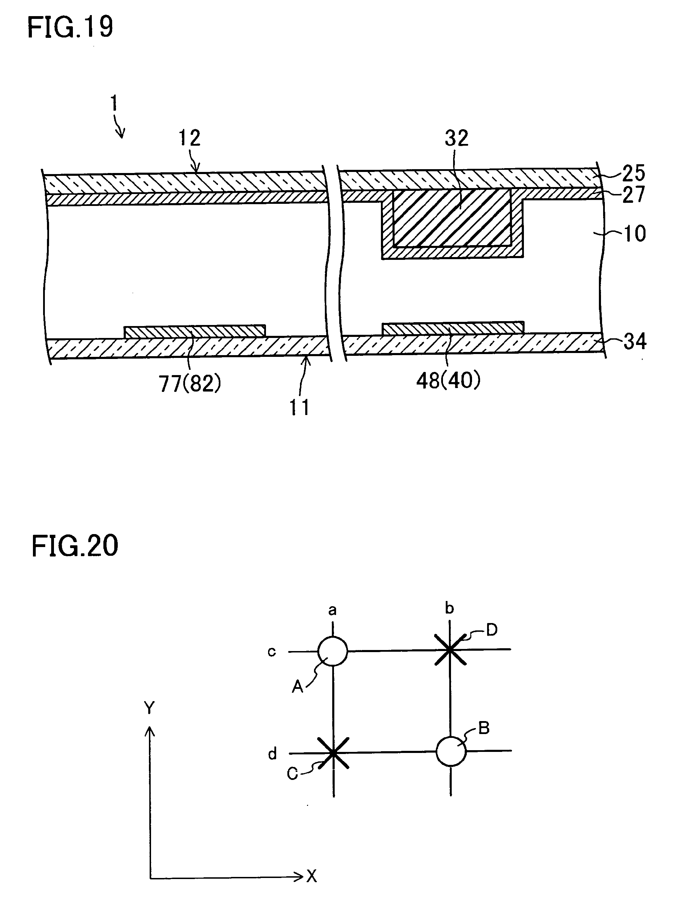

FIGS. 18 and 19 illustrate a fifth embodiment of the present invention.

FIG. 18 is a plan view schematically illustrating a circuit configuration of a TFT substrate 11 included in a liquid crystal display device 1 of the fifth embodiment. FIG. 19 is a cross-sectional view schematically illustrating a structure of the liquid crystal display device 1 of the fifth embodiment.

In the fourth embodiment, each conductive layer 43 provided on the counter substrate 12 is arranged to face the first electrode 41 and the second electrode 42 provided on the TFT substrate 11. In contrast, in the fifth embodiment, a counter electrode 27 formed on a counter substrate 12 is arranged to face detection electrodes 48 formed on the TFT substrate 11.

That is, as illustrated in FIG. 18, each of detection sections 40 of the fifth embodiment includes an associated one of the detection electrodes 48 provided in pixels 5. The detection electrodes 48 are made of a transparent conductive film such as ITO which is the same material as pixel electrodes 15. Moreover, in each pixel 5, a TFT 36 serving as a detection element 22 is provided, and is connected to the detection electrode 48. Moreover, the TFTs 36 are also connected to scan lines 17 and detection lines 18. In this way, when each scan line 17 is scanned, the TFT 36 is turned on, thereby allowing a flow of a current from the detection electrode 48 toward the detection line 18.

On the counter substrate 12, as illustrated in FIG. 19, touch sensor projections 32 are formed in regions facing the detection electrodes 48. The touch sensor projections 32 are covered with the counter electrode 27.

Moreover, in the fifth embodiment, similar to the fourth embodiment, a first inspection circuit 70a is connected to the plurality of scan lines 17 in parallel, and a second inspection circuit 70b is connected to the plurality of detection lines 18 in parallel.

The first inspection circuit 70a includes an inspection line 81, TFTs 76 each serving as a dummy element connected to the inspection line 81, dummy electrodes 77 connected to the TFTs 76, and a reference voltage line 83 connected to the TFTs 76 via the dummy electrodes 77. Each dummy electrode 77 has the same configuration as the detection electrode 48. The scan lines 17 are connected to gate electrodes of the TFTs 76.

Similar to the first inspection circuit 70a, the second inspection circuit 70b includes an inspection line 81, TFTs 76, dummy electrodes 77, and a reference voltage line 83. The detection lines 18 are connected to gate electrodes of the TFTs 76.

### -Method for Detecting Pressed Position-

To detect a pressed position, a Hi voltage is sequentially supplied to the scan lines 17 from a scan driver 53, thereby scanning the scan lines 17. The TFTs 36 connected to the scanned scan lines 17 are turned on.

Here, the TFT substrate 11 or the counter substrate 12 is pressed to bring the counter electrode 27 covering the touch sensor projections 32 into contact with the detection electrodes 48 facing the touch sensor projections 32, thereby establishing conduction between the counter electrode 27 and the detection electrode 48, so that a voltage applied to the counter electrode 27 is output to the detection line 18 via the detection electrode 48 and the TFT 36 in the on state. In this way, the pressed position is detected.

### -Inspection Method-

To inspect the scan lines 17, a predetermined reference voltage is applied to the reference voltage line 83 connected to the scan lines 17. When an inspection signal is sequentially input to the scan lines 17, the TFTs 76 connected to the scan lines 17 are turned on. Thus, the voltage of the reference voltage line 83 is output to the inspection line 81 via the dummy electrodes 77 and the TFTs 76. Whether or not the scan lines 17 have a failure is determined based on whether or not the inspection signal is output to the inspection line 81, and the level of output voltage value of the inspection signal.

On the other hand, to inspect the detection lines 18, a predetermined reference voltage is applied to the reference voltage line 83 connected to the detection lines 18. When an inspection signal is input to the inspection line 81, the TFTs 76 are turned on. Thus, the voltage of the reference voltage line 83 is output to the detection lines 18 via the dummy electrodes 77 and the TFTs 76. Whether or not the detection lines 18 have a failure is determined based on whether or not the inspection signal is output to the detection lines 18, and the level of output voltage value of the inspection signal.

### -Advantages of Fifth Embodiment-

Therefore, also in the fifth embodiment, similar to the first embodiment, a plurality of pressed positions can be detected at a high accuracy by the detection sections 40 each provided to associated one of the pixels 5. In addition, when the scan lines 17 and the detection lines 18 are inspected, it is no longer necessary to wastefully discard counter substrates 12. Thus, production cost can be significantly reduced.

### «Other Embodiments»

Although the dummy circuit sections 82 are provided between the inspection line 81 and the scan lines 17 in the embodiments, the scan lines 17 may be directly connected to the inspection line 81 without the circuit sections 82. The scan lines 17 can be inspected for a failure also in this configuration.

Moreover, although each of the embodiments describes the liquid crystal display device as an example, the present invention is likewise applicable to other display devices such as organic EL display devices using light-emitting layers as, for example, display medium layers.

### INDUSTRIAL APPLICABILITY

As described above, the present invention is useful for display devices for detecting position information on display screens.

### DESCRIPTION OF REFERENCE CHARACTERS

- 1: Liquid Crystal Display Device
- 5: Pixel
- 11: TFT Substrate (First Substrate)
- 12: Counter Substrate (Second Substrate)
- 15: Pixel Electrode
- 16: TFT (Switching Element)
- 17: Scan Line
- 18: Detection Line
- 22: TFD (Detection Element)
- 27: Counter Electrode
- 35, 36: TFT (Detection Element)
- 40: Detection Section
- 41: First Electrode (Detection Electrode)
- 42: Second Electrode (Detection Electrode)
- 43: Conductive Layer
- 48: Detection Electrode
- 53: Scan Driver
- 54: Detection Driver
- 71: First Dummy Electrode
- 72: Second Dummy Electrode
- 73: TFD (Dummy Element)
- 74: Connection Portion
- 75, 76: TFT (Dummy Element)
- 77: Dummy Electrode
- 81: Inspection Line
- 82: Circuit Section

## Claims

1. A display device including
a first substrate,
a second substrate arranged to face the first substrate, where a counter electrode is formed on the second substrate, and
a plurality of pixels formed on the first substrate, where a pixel electrode facing the counter electrode and a switching element connected to the pixel electrode are formed in each pixel, the display device comprising:
detection sections each of which is arranged in an associated one of the pixels, and is configured to detect a position in which the first substrate or the second substrate is pressed;
a plurality of scan lines and a plurality of detection lines formed on the first substrate, and connected to the detection sections;
a scan driver formed on the first substrate, connected to the scan lines, and configured to sequentially supply a scan voltage to the scan lines; and
a detection driver formed on the first substrate, and connected to the detection lines, wherein
the detection driver is configured such that when an area of the first substrate or the second substrate is pressed, and the detection section in the pressed area is scanned with the scan line, a voltage applied to the detection section is detected via the detection line connected to the detection section, and
an inspection line is formed on the first substrate, where at least the scan lines or the detection lines are connected to the inspection line in parallel, and an inspection signal is input from or output to the inspection line.

2. The display device of claim 1, wherein
each of the detection sections includes a detection electrode electrically insulated from the pixel electrode, and a detection element connected to the detection electrode,
the detection electrode includes a first electrode and a second electrode which are electrically insulated from each other, and are arranged in alignment with each other,
a plurality of conductive layers are formed on the second substrate, where each of the conductive layers is arranged to face both the first electrode and the second electrode in each of the pixels, and
the detection element is connected to the first electrode or the second electrode.

3. The display device of claim 2, wherein
circuit sections are provided between the inspection line and the scan lines or between the inspection line and the detection lines,
each of the circuit sections includes a first dummy electrode having an identical configuration to the first electrode, a second dummy electrode having an identical configuration to the second electrode, and a dummy element having an identical configuration to the detection element, and
the first dummy electrode is electrically connected to the second dummy electrode via a connection portion.

4. The display device of claim 2 or 3, wherein
the detection element is a thin film diode or a thin film transistor.
